Europäisches Patentamt

European Patent Office

Office européen des brevets

(11) Numéro de publication : **0 462 882 A1**

# (12) DEMANDE DE BREVET EUROPEEN

(21) Numéro de dépôt : **91401613.4**

(22) Date de dépôt : **17.06.91**

(51) Int. Cl.⁵ : **H01L 29/784, H01L 29/808, H01L 21/74**

(30) Priorité : **19.06.90 FR 9007655**

(43) Date de publication de la demande :
**27.12.91 Bulletin 91/52**

(84) Etats contractants désignés :
**DE GB IT NL**

(71) Demandeur : **COMMISSARIAT A L'ENERGIE ATOMIQUE**
**31-33, rue de la Fédération**
**F-75015 Paris (FR)**

(72) Inventeur : **Blanc, Jean-PHilipp**
**1d, rue de la Gare**
**F-38610 Gieres (FR)**
Inventeur : **Bonaime, Joelle**
**6, rue de Provence**
**F-38130 Echirolles (FR)**
Inventeur : **Du Port de Poncharra, jean**
**Hameau de Peteysset**
**F-38950 Quaix-en-Chartreuse (FR)**
Inventeur : **Truche, Robert**
**11, RUE WILSON**
**F-38601 Gières (FR)**

(74) Mandataire : **Mongrédien, André et al**
**c/o BREVATOME 25, rue de Ponthieu**
**F-75008 Paris (FR)**

(54) **Transistor à effet de champ en couche mince avec grille enterrée et son procédé de fabrication.**

(57)    Ce circuit comprend notamment un transistor JFET comportant une source et un drain (42, 44) isolés, d'un type de conductivité dans la partie supérieure 16 d'un îlot (18) semi-conducteur, une grille supérieure (35) entre la source et le drain, une couche isolante enterrée (4) supportant l'îlot, une grille enterrée (12) dans l'îlot et au contact de la couche isolante, cette électrode présentant un second type de conductivité différent du premier, une zone diffusée (36) dans au moins un flanc (18a) de l'îlot à partir d'un matériau conducteur (29) recouvrant ledit flanc, ce matériau conducteur étant dopé avec des impuretés du second type de conductivité, la zone diffusée du second type de conductivité étant isolée électriquement des source et drain et assurant la prise de contact électrique de l'électrode et le matériau conducteur constituant le contact électrique de l'électrode, et des contacts de source, de drain (50) et de grille (31) isolés électriquement entre eux et du contact de l'électrode.

FIG. 1K

EP 0 462 882 A1

L'invention a pour objet un circuit intégré en technologie semi-conducteur sur isolant comportant au moins un transistor à effet de champ à jonctions (JFET) et/ou un transistor à effet de champ à grille isolée (MIS) ainsi que son procédé de fabrication.

Elle s'applique dans le domaine des circuits intégrés présentant une grande rapidité de fonctionnement, une tenue aux hautes tensions et éventuellement une grande résistance aux radiations ionisantes et devant dissiper de fortes puissances.

La technologie silicium sur isolant ou technologie SSI constitue une amélioration sensible dans le domaine de la microélectronique par rapport aux techniques de réalisation de circuits intégrés sur un substrat semi-conducteur massif. En effet, l'emploi d'un support isolant conduit à une forte diminution des capacités parasites entre la source des transistors et le substrat d'une part, et le drain de ces transistors et le substrat d'autre part, et donc à un accroissement de la vitesse de fonctionnement des circuits intégrés.

L'une des techniques connues de réalisation d'un transistor à jonctions JFET à canal n consiste à implanter une zone de type n à la surface d'un substrat en silicium de type p fortement dopé, qui constituera la grille enterrée du transistor, à graver le silicium pour former un îlot contenant la zone de type n puis à oxyder thermiquement l'îlot de silicium.

Une couche de silicium polycristallin est alors déposée puis le silicium de départ est gravé jusqu'au pied de l'îlot.

Les zones de source, de drain et de grille sont alors formées sur la face arrière de l'îlot en implantant des ions de type p pour les source et drain et de type n pour la grille. Le contact électrique sur la grille enterrée est réalisé par diffusion d'ions de type n à travers le substrat de type p.

La fabrication d'un JFET à canal p sur isolant se fait de la même façon en intervertissant simplement les régions n et p et le type des impuretés dopantes.

L'isolation électrique entre deux transistors JFET d'un même circuit est assurée grâce à la gravure des îlots semi-conducteurs et à leur oxydation.

Une autre technique connue de fabrication d'un JFET à canal n sur isolant consiste à implanter des ions d'oxygène dans un substrat en silicium monocristallin puis à recuire l'ensemble pour former un film de silicium monocristallin supporté par une couche de SiO$_2$.

On forme alors, par implantation ionique, la grille enterrée du transistor dans le film semiconducteur, puis on épitaxie une couche épaisse de silicium sur le film semi-conducteur.

Les régions de grille, de source et de drain sont formées à la surface de la couche épitaxiée par implantation ionique d'ions respectivement de type n pour la grille et p pour la source et le drain. La prise de contact électrique sur la grille enterrée se fait par implantation ionique de la même manière que le puits collecteur dans un transistor bipolaire, c'est-à-dire en effectuant différentes implantations d'ions à des profondeurs différentes de type n+, puis diffusion par traitement thermique pour obtenir le contact avec la grille enterrée.

L'isolation électrique entre deux transistors d'un même circuit intégré est alors réalisée par un oxyde de champ localisé du type LOCOS.

Ces méthodes de fabrication de transistors JFET sur isolant sont très délicates et complexes. En outre, leur fiabilité est inférieure à celle des techniques classiques de fabrication d'un transistor JFET sur un semi-conducteur massif.

Par ailleurs, la première technique est assez différente des technologies généralement utilisées en microélectronique et la seconde technique utilise un isolement entre les différents dispositifs par un oxyde de champ localisé qui présente une mauvaise tenue aux radiations ionisantes.

L'une des techniques connues de réalisation d'un transistor MIS de type n sur un support isolant, connue sous l'abréviation SOS, consiste à épitaxier une couche de silicium monocristallin sur un substrat en saphir, à graver cette couche pour former des îlots de silicium, à implanter des ions de type n sur les flancs de ces îlots pour former les régions de source et de drain, à oxyder thermiquement ces îlots, à graver la couche d'oxyde ainsi formée pour constituer l'oxyde de grille, à déposer une couche de silicium polycristallin dopé n+ sur les îlots obtenus et graver cette couche pour définir des contacts de source et de drain et la grille.

La réalisation de ces transistors MIS est relativement simple. Toutefois, ce procédé présente l'inconvénient d'un coût de fabrication élevé et d'un rendement faible. En outre, il est difficile de contrôler électriquement le transistor sous le canal.

Une autre technologie de fabrication d'un transistor MIS sur isolant consiste à implanter des ions d'oxygène dans un substrat en silicium monocristallin, à recuire l'ensemble pour former un film de silicium monocristallin supporté par une couche de SiO$_2$ enterrée. Le transistor MIS est alors réalisé dans ce film de silicium avec la technologie standard utilisée sur semi-conducteur massif. L'isolation de ces transistors est réalisée par une oxydation localisée du type LOCOS.

Cette technologie simple ne permet pas non plus un bon contrôle électrique du transistor sous le canal. En outre, il existe un transistor parasite en bordure du LOCOS. Par ailleurs, ce type d'isolation entre transistor présente généralement une tenue aux radiations ionisantes insuffisante.

L'invention a donc pour objet un circuit intégré en technologie semi-conducteur sur isolant comportant un transistor à effet de champ du type JFET ou MIS ainsi que son procédé de fabrication, permettant de remédier aux différents inconvénients mentionnés ci-dessus.

En particulier, ce circuit présente tous les avantages de la technologie semi-conducteur sur isolant et en particulier silicium sur isolant. Son procédé de fabrication est beaucoup plus simple que celui de l'art antérieur tout en utilisant une technologie classique en microélectronique. De plus, il est possible de réaliser la grille enterrée d'un transistor JFET soit sous le canal du transistor uniquement, soit sous le canal et la source uniquement, soit sur toute la surface de l'isolant, permettant ainsi d'adapter le circuit obtenu aux différentes applications et d'avoir une bonne tenue en tension.

De façon plus précise, l'invention a pour objet un circuit intégré comprenant au moins un transistor à effet de champ comportant une source et un drain dans la partie supérieure d'un îlot semi-conducteur, obtenus par introduction locale d'impuretés d'un premier type de conductivité, une grille située sur l'îlot entre la source et le drain et isolée électriquement de ces dernières, une couche isolante électrique enterrée supportant l'îlot, une électrode enterrée dans l'îlot et au contact de la couche isolante, cette électrode présentant un second type de conductivité différent du premier, une zone diffusée dans au moins un flanc de l'îlot à partir d'un matériau conducteur recouvrant ledit flanc, ce matériau conducteur étant dopé avec des impuretés du second type de conductivité, la zone diffusée du second type de conductivité étant isolée électriquement des source et drain et assurant la prise de contact électrique de l'électrode et le matériau conducteur constituant le contact électrique de l'électrode, et des contacts de source, de drain et de grille isolés électriquement entre eux et du contact de l'électrode.

De façon avantageuse, la grille et le contact électrique de l'électrode enterrée sont réalisés dans une même couche conductrice dopée gravée de façon appropriée.

Ainsi, la connexion de l'électrode enterrée par diffusion d'impuretés sur les flancs gravés de l'îlot semi-conducteur n'apporte aucune étape technologique supplémentaire. En effet, les étapes de dépôt et de gravure d'une couche conductrice sont nécessaires pour la réalisation de la grille supérieure.

Le pincement du canal de ce transistor se fait à l'aplomb du canal par polarisation des grilles supérieure et enterrée.

L'électrode enterrée a l'avantage de masquer l'interface semi-conducteur-isolant, avantage important sous irradiation ionisante, car ceci permet une bonne tenue aux radiations.

Pour un circuit à plusieurs transistors, la possibilité de faire varier la forme des électrodes enterrées permet d'assurer au circuit une bonne tenue en tension entre les différentes électrodes enterrées, chaque électrode enterrée pouvant avoir sa propre forme, différente de celle des autres électrodes enterrées.

La couche d'isolant peut être une couche de nitrure de silicium ou d'oxyde de silicium, obtenue avantageusement par une ou plusieurs implantations ioniques respectivement d'azote ou d'oxygène dans un substrat en silicium monocristallin, à des doses élevées mais ne rendant pas le silicium amorphe, suivies d'un recuit assurant d'une part, la guérison des défauts engendrés dans le substrat et en particulier dans le film de silicium monocristallin formé sur la couche d'isolant, lors de l'implantation et d'autre part, la continuité de la couche isolante.

Pour de plus amples informations sur cette technique de fabrication d'une structure SSI, on peut se référer au document FR-A-2 616 590 déposé le 15 juin 1987 au nom du demandeur.

Il est toutefois possible d'obtenir cette structure SSI par épitaxie d'un film de silicium monocristallin sur un isolant tel que le saphir ou par dépôt d'une couche de silicium amorphe ou polycristallin sur un substrat amorphe tel que du verre ou de la silice puis recristallisation du silicium.

L'utilisation d'une couche isolante enterrée permet de contrôler électriquement le transistor sous Le canal : c'est donc une vraie prise substrat.

De façon avantageuse, l'îlot semi-conducteur est constitué d'un film monocristallin sur lequel on a épitaxié une couche plus épaisse semi-conductrice, ce film et cette couche semi-conductrice étant gravés.

L'électrode enterrée pour les transistors JFET constitue une véritable grille enterrée, ce qui n'est pas le cas pour les transistors MIS. Pour ces derniers, l'électrode enterrée qui est directement au contact de la couche semi-conductrice épitaxiée, est adressable indépendamment pour chaque transistor. Elle ne peut être assimilée à une grille enterrée car elle est du même type de conductivité que celui de la couche épitaxiée contrairement aux transistors JFET.

Cette électrode n'existe pas dans les transistors MIS classiques.

Pour un circuit intégré comportant deux transistors à effet de champ, l'isolation électrique entre ces deux transistors est assurée grâce à l'espace séparant les deux îlots, ces derniers étant obtenus par gravure d'un même matériau semi-conducteur sur toute son épaisseur, et non à l'aide d'une oxydation localisée du type LOCOS, éliminant ainsi les problèmes liés à ce type d'isolation.

L'invention a aussi pour objet un procédé de fabrication de ce circuit intégré. En particulier, ce procédé comprend au moins un transistor à effet de champ, comprenant les étapes suivantes :

    a) - formation d'une couche isolante électrique, enterrée dans un substrat semi-conducteur,

    b) - dopage du matériau semi-conducteur supporté par la couche isolante, avec des impuretés d'un premier type de conductivité, pour former une couche conductrice enterrée, au contact de la couche isolante,

c) - gravure du matériau semi-conducteur supporté par la couche isolante jusqu'à cette couche isolante, pour former un îlot semi-conducteur,

d) - isolation électrique des zones de source, de drain et de grille du transistor,

e) - réalisation des source et drain dans la partie supérieure de l'îlot semi-conducteur par introduction locale d'impuretés d'un second type de conductivité différent du premier type,

f) - réalisation de la grille et du contact de grille du transistor sur l'îlot, entre la source et le drain,

g) - formation d'un matériau conducteur dopé par des impuretés du premier type de conductivité, sur au moins un flanc de l'îlot semi-conducteur,

h) - traitement thermique de la structure obtenue en g) pour faire diffuser les impuretés du matériau conducteur dopé dans le flanc de l'îlot et former ainsi une prise de contact électrique sur la couche conductrice enterrée, isolée des source et drain, le contact électrique étant assuré par le matériau conducteur,

i) - réalisation des contacts électriques des source et drain du transistor, isolés électriquement entre eux et de ceux de l'électrode et de la grille.

Le dopage du matériau conducteur peut être fait avantageusement après le dépôt du matériau conducteur. Il est toutefois possible de déposer directement le matériau conducteur sous forme dopée.

Le procédé de l'invention a l'avantage d'utiliser une technologie classique en microélectronique, ne modifiant pas les installations actuellement utilisées.

En outre, les différentes étapes de ce procédé sont non critiques et compatibles avec la réalisation de transistors JFET ou MIS complémentaires, réalisés sur un même substrat.

Dans ce cas, le dopage de type n du matériau conducteur sur les flancs d'îlots destinés aux transistors (JFET ou MIS) à source et drain de type p résulte d'un dopage de type n de toute la structure en masquant les îlots destinés aux transistors à source et drain de type n et le dopage de type p du matériau conducteur sur les flancs d'îlots destinés aux transistors à source et drain de type n résulte d'un dopage de type p de toute la structure en masquant cette fois les îlots destinés aux transistors à source et drain de type p. Un tel dopage complémentaire, après dépôt du matériau à doper, n'est pas possible avec un verre ; le dopage d'un verre ne peut être fait que lors de son dépôt.

De façon avantageuse, on épitaxie sur le film semi-conducteur une couche semi-conductrice, les source et drain étant alors formés dans la couche épitaxiée et la couche conductrice enterrée dans le film semi-conducteur.

La couche semi-conductrice est formée par épitaxie à basse température sur une faible épaisseur, c'est-à-dire à une température inférieure à la température de fusion du silicium et sur une épaisseur de 500 à 2000nm.

D'autres caractéristiques et avantages de l'invention ressortiront mieux de la description qui va suivre, donnée à titre illustratif et non limitatif, en référence aux dessins annexés dans lesquels :

– les figures 1A à 1K et 2 représentent schématiquement les différentes étapes de fabrication d'un circuit intégré à transistors JFET, conforme à l'invention ; les figures 1A-1K étant des coupes longitudinales et la figure 2 une vue de dessus de la figure 1J ;

– les figures 3A à 3L et 4 représentent schématiquement les différentes étapes de fabrication d'un circuit intégré à transistors MOS, conforme à l'invention ; les figures 3A-3L sont des vues en coupe longitudinale et la figure 4 est une vue de dessus de la figure 3K.

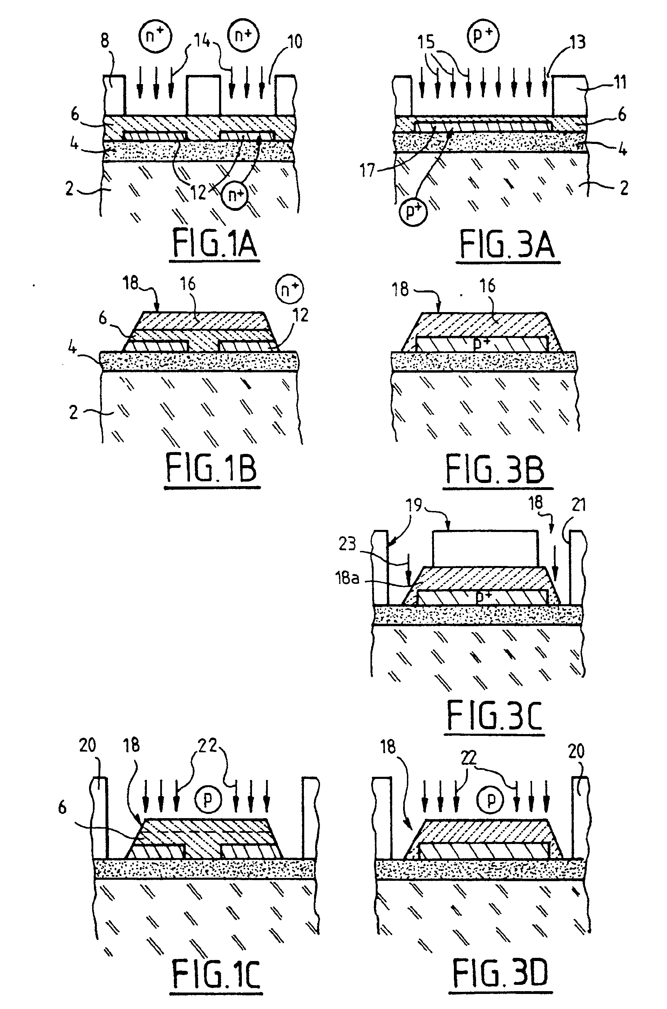

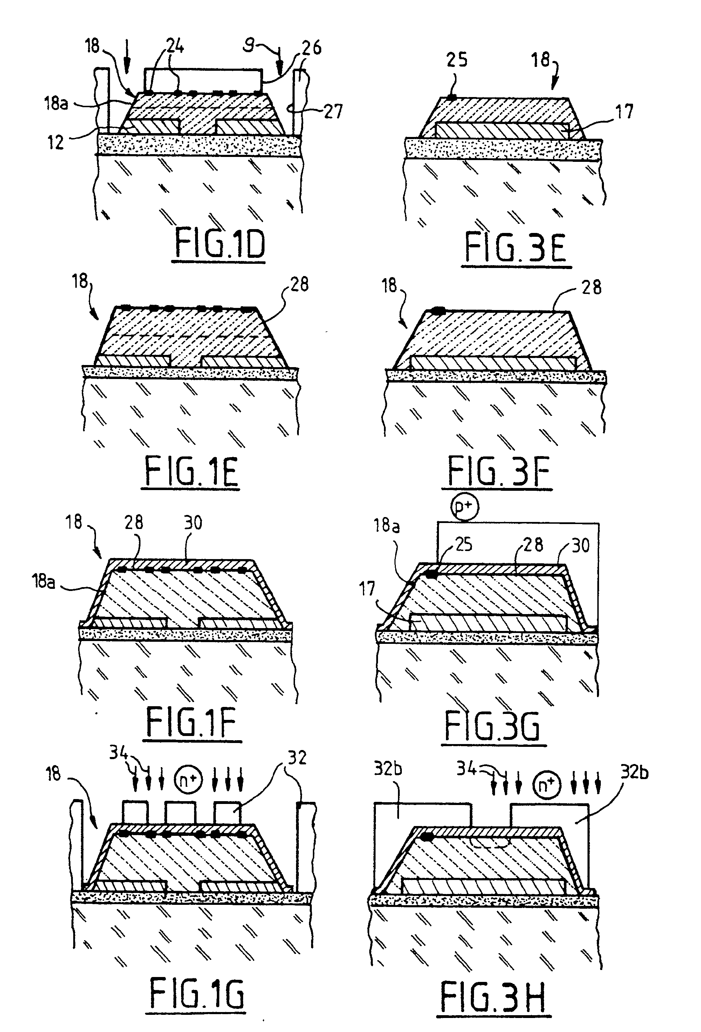

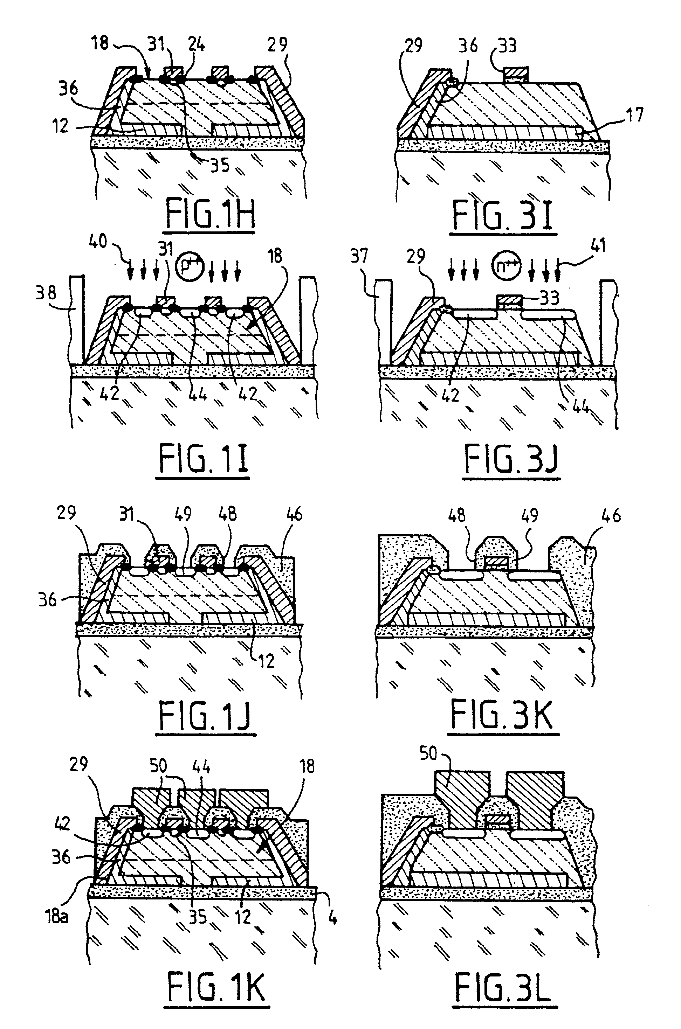

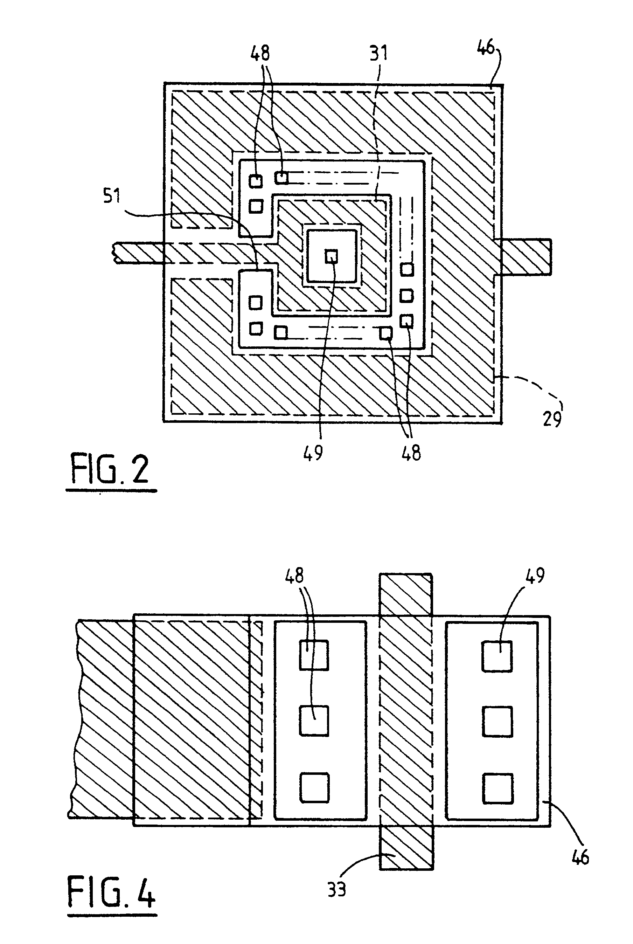

La description qui suit, en référence aux figures 1A-1K et 2 est relative à la fabrication d'un circuit intégré à transistors JFET à canal p et la description en référence aux figures 3A-3L et 4 est relative à la fabrication d'un circuit intégré à transistors MOS à canal n, mais bien entendu., l'invention est d'application beaucoup plus générale et s'applique notamment à la réalisation de circuits intégrés à transistors JFET à canal n ou à transistors MOS à canal p ainsi qu'à des circuits CJFET ou CMOS comportant à la fois des transistors à canal n et des transistors à canal p.

Pour des raisons de simplification, on n'a représenté qu'un seul transistor sur ces figures.

En référence à la figure 1A, la première étape de fabrication d'un circuit intégré à transistors p-JFET consiste à former sur un substrat 2 en silicium monocristallin une couche 4 isolante électrique à une profondeur de 200 nanomètres environ et sur une épaisseur de 400 nm, supportant un film de silicium monocristallin 6 de 200nm d'épaisseur. Cette couche 4 est réalisée de préférence en $SiO_2$.

Cette structure silicium sur isolant peut être obtenue par implantation d'ions oxygène dans le substrat 2 à une énergie de 100 à 400 keV et une dose de 1 à $2.10^{18}$ at/cm$^2$ suivie d'un recuit à 1350°C.

On réalise ensuite, par photolithographie un masque de résine 8 dont les ouvertures 10 définissent la forme et les dimensions des grilles inférieures ou enterrées des transistors à réaliser. Avec le masque représenté sur la figure 1A, on réalise une grille inférieure enterrée 12 présentant en section des formes intérieure et extérieure carrées comme représenté sur la figure 2 et une épaisseur constante.

Cette grille enterrée 12 est obtenue en implantant des ions de type n+ dans le film 6 et en particulier des ions de phosphore ou d'arsenic à une dose de

$10^{15}$at/cm$^2$ et une énergie de 50keV. Cette implantation symbolisée par les flèches 14 peut se faire accessoirement à travers une couche mince de protection notamment en SiO$_2$ de 10 à 20nm d'épaisseur obtenue par oxydation thermique du film de silicium 6.

Après élimination du masque 10, on peut effectuer de façon avantageuse un recuit de la structure à environ 1000°C pour assurer la diffusion des ions n+ implantés jusqu'à la couche d'isolant 4, et former ainsi des grilles enterrées n+ au contact de l'isolant 4, dans le film 6.

On épitaxie alors sur le film de silicium 6 une couche de silicium monocristallin 16 de 1μm d'épaisseur par exemple à une température inférieure ou égale à 1000°C. A l'aide d'un masque photolithographique, non représenté, on effectue alors une gravure de la couche 16 puis du film 6 par exemple par voie humide en utilisant une solution de potasse ou par voie sèche (gravure réactive ou non, gravure plasma) afin de former des îlots semi-conducteurs 18 dont la forme et les dimensions fixent celles des transistors à réaliser.

Cette gravure est réalisée de façon sélective en s'arrêtant sur la couche isolante 4. Elle permet en outre de séparer électriquement les transistors entre eux ; ceci permet de supprimer l'isolation de type LOCOS.

La structure obtenue est celle représentée sur la figure 1B.

L'étape suivante consiste à réaliser un masque photolithographique 20 en résine masquant toute la structure du circuit intégré à l'exception des îlots destinés à la fabrication des transistors p-JFET. A l'aide de ce masque 20, on effectue une implantation ionique 22 dans le canal des transistors. Cette implantation est réalisée à l'aide des ions de type p et en particulier de bore à une dose de $10^{12}$at/cm$^2$ et une énergie de 150 keV, comme représenté sur la figure 1C.

Après élimination du masque d'implantation 20, on effectue dans la partie supérieure des îlots semi-conducteurs 18 des isolations latérales localisées, destinées à isoler électriquement entre eux les source, drain et grille de chaque transistor et à isoler les source et drain de la zone de contact électrique de la grille enterrée 12. Cette isolation localisée porte la référence 24 et a une épaisseur de 200nm environ ; elle peut être du type LOCOS ou bien obtenue par dépôt d'un isolant puis gravure de celui-ci.

La structure obtenue est seule représentée sur la figure 1D, avec une isolation de type LOCOS.

On effectue alors, éventuellement, une passivation des flancs gravés 18a des îlots semi-conducteurs 18. Cette passivation est obtenue par un dopage des flancs en utilisant un masque 26 ne comportant des ouvertures 27 qu'en regard des flancs gravés. Ce dopage peut être réalisé par implantation 9 d'ions bore à une dose de $10^{12}$ à $10^{13}$at/cm$^2$ et une énergie de 50 keV par exemple. Ce dopage des flancs 18a permet de diminuer les courants de fuite des transistors.

On effectue ensuite, comme représenté sur la figure 1E, une oxydation thermique des îlots 18 pour former une couche d'oxyde de silicium 28 de 40nm d'épaisseur environ. Cet oxyde 28 est ensuite gravé sélectivement par rapport au silicium des îlots 18 de façon à éliminer l'isolant à l'emplacement des jonctions de grille et des contacts de ces jonctions, à réaliser. La structure obtenue est celle représentée sur la figure 1F. En particulier, l'isolant 28 est éliminé sur les flancs 18a et entre les isolations 24 où sera formée la grille supérieure de chaque transistor. A chaque grille supérieure correspond une grille enterrée, disposées en regard l'une de l'autre.

La gravure de la couche de SiO$_2$ 28 peut être réalisée par voie humide et nécessite un masque photolithographique, non représenté.

On dépose ensuite une couche 30 de silicium polycristallin intrinsèque sur l'ensemble des îlots 18, présentant une épaisseur de 500nm par exemple, ce dépôt est réalisé par la technique de dépôt chimique en phase vapeur basse pression (LPCVD).

L'étape suivante du procédé, comme représenté sur la figure 1G, consiste à former un nouveau masque lithographique 32 de résine masquant l'ensemble du circuit intégré à l'exception des îlots 18 destinés à la fabrication des transistors JFET à canal p ainsi que les régions de source et de drain de ces transistors.

A travers ce masque 12, on effectue une implantation ionique 34 avec des ions de type n+ et en particulier des ions de phosphore ou d'arsenic à une énergie de 50 keV et une dose de $10^{15}$ at/cm$^2$. Cette implantation ionique assure le dopage de type n+ de la couche 30 de silicium polycristallin, en regard d'une part, de la jonction de chaque grille supérieure et du contact correspondant à réaliser, et d'autre part, de la prise de contact et du contact correspondant de chaque grille enterrée 12.

Après élimination du masque d'implantation 32, on effectue, comme représenté sur la figure 1H, une gravure de la couche semi-conductrice 30 localement dopée de façon à éliminer cette couche aux endroits de source et drain du transistor, correspondant aux zones non dopées de la couche 30. Cette gravure est effectuée au moyen d'un masque non représenté et peut être réalisée par gravure ionique réactive en utilisant du SF$_6$, l'arrêt de gravure étant déterminé par le temps.

On élimine ensuite, par gravure, l'isolant 28 recouvrant les zones de source et de drain, mises à nu lors de la gravure de la couche 30.

Cette étape de gravure permet de réaliser, simultanément, le contact de la grille 31 supérieure de chaque transistor, ainsi que le contact électrique 29 de chaque grille enterrée. Le contact 29 de chaque grille enterrée recouvre les flancs 18a de l'îlot correspondant. Le contact 31 de la grille supérieure a en section des formes intérieure et extérieure carrées et une épaisseur constante (voir figure 2).

On effectue ensuite un traitement thermique de la structure à 900°C environ, de façon à assurer une diffusion locale, dans l'îlot semi-conducteur 18, des ions n+ implantés au cours de l'implantation 34. On obtient ainsi, pour chaque transistor, la jonction de grille 35 à l'aplomb du contact de grille 31 et une zone diffusée 36 sur le flanc de l'îlot assurant la prise de contact électrique de la gille enterrée 12.

On effectue ensuite, comme représenté sur la figure 11, un nouveau masque d'implantation 38 masquant le circuit intégré à l'exception des îlots 18 destinés à la réalisation des JFET à canal p.

A travers ce masque 38, les contacts 29 et la grille supérieure 31, on effectue une implantation 40 d'ions de type p++ et en particulier d'ions de bore à une dose de $10^{15}$at/cm$^2$ et une énergie de 20 keV. Cette implantation conduit à la formation des régions de source 42 et de drain 44 des transistors. Le drain a la forme d'un carré en vue de dessus et est entouré par la source 42 qui a en section des formes intérieure et extérieure carrées et une épaisseur constante.

Après élimination du masque d'implantation 38, on effectue un recuit thermique à 900°C pour guérir les défauts créés au cours de l'implantation et activer les ions implantés. Ensuite, on dépose sur l'ensemble de la structure un isolant électrique 46 et en particulier d'oxyde de silicium de 500nm d'épaisseur. On effectue ensuite une gravure de cet isolant pour former les trous de contact 48 et 49 des régions respectivement de source et de drain. La structure obtenue est représentée sur les figures 1J et 2.

La dernière étape du procédé, comme représenté sur la figure 1K, consiste à déposer sur l'ensemble de la structure une couche de métallisation, puis à graver cette dernière pour former des contacts 50 sur les zones de source et de drain. Cette métallisation est en particulier de l'aluminium de 1um d'épaisseur.

La description qui suit se rapporte à la fabrication d'un circuit intégré à transistors n-MOS en référence aux figures 3A-3L ; les éléments de ce circuit identique à celui décrit précédemment, porteront les mêmes références.

Après formation de la couche d'isolant enterrée 4 et du film de silicium polycristallin 6 sur le substrat en silicium 2, on réalise, comme représenté sur la figure 3A, un masque photolithographique de résine 11, destiné à masquer toutes les régions du circuit intégré à l'exception des régions destinées à la fabrication des transistors à canal n. Ce masque comporte en particulier une ouverture 13 en regard de la région dans laquelle on désire réaliser le transistor n-MOS.

A l'aide de ce masque 11, on effectue alors dans le film 6 une implantation 15 d'ions de type p et en particulier de bore à une énergie de l'ordre de 50keV et une dose de $10^{15}$at/cm$^2$. On obtient ainsi, éventuellement après un recuit thermique à 1000°C, une électrode enterrée 17 de type p+ dans le film 6, ayant une épaisseur identique ou supérieure à celle de la grille 12 enterrée du transistor p-JFET. Cette électrode a la forme d'un parallélépipède rectangle, comme dans l'art antérieur, et est située au contact de la couche isolante 14.

Cette implantation peut aussi se faire à travers une couche de protection, comme décrit précédemment en référence à la figure 1A.

Sur le film de silicium 6, on épitaxie alors la couche de silicium 16 dans les mêmes conditions que décrit précédemment.

Comme représenté sur la figure 3B, l'électrode enterrée 17 peut être située au contact direct de la couche épitaxiée 16, contrairement à la grille enterrée 12 des transistors p-JET représentés sur la figure 1B.

On grave alors l'empilement des couches de silicium 6 et 16 pour former l'îlot 18 semi-conducteur, comme décrit précédemment.

On forme alors, comme représenté sur la figure 3C, un masque photolithographique en résine 19 comportant des ouvertures 21 uniquement en regard des flancs gravés 18a des îlots 18 destinés à la fabrication de transistors n-MOS. On effectue alors un dopage des flancs 18a afin de diminuer les courants de fuite des transistors n-MOS. Ce dopage est réalisé par implantation 23 des ions de type p tels que des ions bore à une dose de $10^{12}$ at/cm$^2$ et une énergie de 50 keV. On élimine alors le masque 19.

On forme alors, comme représenté sur la figure 3D, le masque d'implantation 20 et on effectue l'implantation 22 d'ions de type p, comme décrit en référence à la figure 1C. Cette implantation dans un transistor MOS est destinée à l'ajustement de la tension de seuil sous le canal du transistor.

On réalise alors, comme représenté sur la figure 3E, une isolation 25 à la surface de l'îlot semi-conducteur 18 par dépôt puis gravure ou par oxydation localisée du type LOCOS destinée à isoler les zones de drain et de source des transistors de la zone de contact électrique de l'éléctrode enterrée 17. Cet isolant 25 a une épaisseur de 200nm environ.

On effectue alors, comme représenté sur la figure 3F, une oxydation 28 des îlots 18, destinée à la réalisation de l'oxyde de grille du transistor n-MOS.

On effectue alors une gravure de l'isolant 28 de façon à éliminer cet isolant à l'endroit où le contact de l'électrode enterrée de chaque transistor n-MOS doit être réalisé et en particulier sur le flanc 18a de l'îlot, à gauche de la figure 3G, adjacent à l'isolation 25.

Cette étape nécessite un masque, non représenté, et revient à ajouter une étape aux étapes technologiques classiques de fabrication des transistors n-MOS. On dépose alors sur l'ensemble des îlots 18 la couche de silicium polycristallin 30.

On forme alors un masque photolithographique 32a de résine masquant l'ensemble du circuit intégré à l'exception des flancs 18a des îlots 18 sur lesquels on va réaliser ultérieurement le contact électrique de l'électrode enterrée 17.

A travers ce masque, on effectue une implantation 39 d'ions de type p+ et en particulier d'ions de bore à une énergie de 20 keV et une dose de $10^{16}$ at/cm². Cette implantation assure un dopage p+ de la couche 30 en silicium polycristallin, en regard de la prise de contact et du contact de chaque électrode enterrée 17 à réaliser.

On forme alors un masque photolithographique 32b destiné au dopage de la couche 30 à l'aplomb de la grille supérieure du transistor n-MOS à réaliser. Ce masque comporte des ouvertures uniquement en regard des grilles supérieures des transistors n-MOS à réaliser. Ce dopage est réalisé par l'implantation 34 d'ions de type n+, comme décrit en référence à la figure 1G.

On effectue alors, comme représenté sur la figure 3I, la gravure de la couche de silicium 30, de façon à réaliser simultanément la grille 33 supérieure du transistor n-MOS puis le contact électrique 29 de l'électrode enterrée 17 du transistor. Seules les zones dopées de la couche 30 sont gardées. Cette gravure est réalisée comme décrit ci-dessus.

On effectue alors le traitement thermique à 900°C destiné à la diffusion des ions de type n+, implantés au cours de l'implantation 34 dans la couche 30, dans le flanc gravé 18a de chaque îlot recouvert du contact électrique 29 de l'électrode enterrée 17 correspondante. La zone diffusée dans l'îlot porte la référence 36.

On effectue alors, comme représenté sur la figure 3J, un masque photolithographique de résine 37 destiné à masquer toutes les zones du circuit intégré à l'exception des îlots destinés à la fabrication des transistors à canal n. A l'aide de ce masque 37, de la connexion électrique 29 et de la grille 33 du transistor, servant de masque d'implantation, ' on effectue une implantation 41 d'ions de type n++, destinée à la formation de la source 42 et du drain 44 du transistor. Cette implantation 41 consiste à implanter en particulier des ions d'arsenic ou de phosphore à une dose de $3.10^{15}$ at/cm² et une énergie de 50 keV.

Après élimination du masque 41, on effectue le recuit thermique de post-implantation. La structure obtenue est celle de la figure 3J.

On dépose alors la couche d'isolant 46 dans laquelle on effectue des ouvertures telles que 48 et 49, destinées respectivement à la prise de contact sur la source, le drain, la grille supérieure et l'électrode enterrée du transistor n-MOS. La structure obtenue est représentée sur les figures 3K et 4.

Le dépôt de cette couche 46 et sa gravure sont réalisés dans les mêmes conditions que décrit en référence à la figure 1J.

On effectue alors le dépôt d'une couche de métal sur l'ensemble de la structure que l'on grave pour former les contacts électriques 50 de source et de drain, comme décrit en référence à la figure 1K. La structure finale du transistor n-MOS est celle représentée sur la figure 3L.

La description ci-dessus a été faite pour une technologie silicium sur isolant mais elle s'applique aussi à toutes les techniques semi-conducteur sur isolant et en particulier aux techniques GaAs sur silicium.

## Revendications

1. Circuit intégré comprenant au moins un transistor à effet de champ comportant une source (42) et un drain (44) dans la partie supérieure (16) d'un îlot semi-conducteur (18), obtenus par introduction locale d'impuretés d'un premier type de conductivité, une grille (35, 33) située sur l'îlot entre la source et le drain et isolée électriquement de ces dernières, une couche isolante électrique enterrée (4) supportant l'îlot, une électrode (12, 17) enterrée dans l'îlot et au contact de la couche isolante, cette électrode présentant un second type de conductivité différent du premier, une zone diffusée (36) dans au moins un flanc (18a) de l'îlot à partir d'un matériau conducteur (29) recouvrant ledit flanc, ce matériau conducteur étant dopé avec des impuretés du second type de conductivité, la zone diffusée du second type de conductivité étant isolée électriquement des source et drain et assurant la prise de contact électrique de l'électrode et le matériau conducteur constituant le contact électrique de l'électrode, et des contacts de source, de drain (50) et de grille (31) isolés électriquement entre eux et du contact de l'électrode.

2. Circuit intégré selon la revendication 1, caractérisé en ce que la grille (31, 33) et le contact électrique (29) de l'électrode enterrée sont réalisés dans une même couche conductrice dopée gravée de façon appropriée.

3. Circuit intégré selon la revendication 1 ou 2, caractérisé en ce que le matériau conducteur est du silicium polycristallin dopé.

4. Circuit intégré selon l'une quelconque des revendications précédentes, caractérisé en ce que l'îlot (18) est en silicium monocristallin et la couche isolante (4) en oxyde ou nitrure de silicium.

5. Circuit intégré selon l'une quelconque des revendications précédentes, caractérisé en ce que l'îlot semi-conducteur est constitué d'un film monocristallin (6) sur lequel on a épitaxié une couche plus épaisse semi-conductrice (16), ce film et cette couche semi-conductrice étant gravés.

6. Circuit intégré selon l'une quelconque des revendications précédentes comprenant au moins deux transistors à effet de champ isolés électriquement, caractérisé en ce que chaque transistor comporte un îlot semi-conducteur sur toute son épaisseur, l'isolation électrique étant assurée par la distance séparant les flancs (18a) des deux îlots.

7. Circuit intégré selon l'une quelconque des revendications précédentes, caractérisé en ce que le transistor est un transistor à jonctions (JFET) ou un transistor à grille isolée (MIS).

8. Procédé de fabrication d'un circuit intégré comprenant au moins un transistor à effet de champ, comprenant les étapes suivantes :
   – a) - formation d'une couche isolante électrique, enterrée (4) dans un substrat semiconducteur (2),
   – b) - dopage du matériau semi-conducteur (6, 6) supporté par la couche isolante, avec des impuretés d'un premier type de conductivité, pour former une couche conductrice (12, 17) enterrée, au contact de la couche isolante,
   – c) - gravure du matériau semi-conducteur supporté par la couche isolante jusqu'à cette couche isolante, pour former un îlot semi-conducteur (18),
   – d) - isolation électrique (24, 25, 28) des zones de source, de drain et de grille du transistor,
   – e) - réalisation des source (42) et drain (44) dans la partie supérieure (16) de l'îlot semi-conducteur par introduction locale d'impuretés d'un second type de conductivité différent du premier type,
   – f) - réalisation de la grille (35, 33) et du contact de grille (31) du transistor sur l'îlot, entre la source et le drain,
   – g) - formation d'un matériau conducteur dopé (29) par des impuretés du premier type de conductivité, sur au moins un flanc de l'îlot semi-conducteur,
   – h) - traitement thermique de la structure obtenue en g) pour faire diffuser les impuretés du matériau conducteur dopé dans le flanc de l'îlot et former ainsi une prise de contact électrique (36) sur la couche conductrice enterrée, isolée des source et drain, le contact électrique (29) étant assuré par le matériau conducteur,
   – i) - réalisation des contacts électriques des source et drain (50) du transistor, isolés entre eux et de ceux de l'électrode et de la grille.

9. Procédé selon la revendication 8, caractérisé en ce que l'étape a consiste à implanter des ions d'oxygène ou d'azote dans le substrat semiconducteur monocristallin et à recuire l'ensemble, formant ainsi la couche isolante (4) enterrée, surmontée d'un film semi-conducteur monocristallin (6).

10. Procédé selon la revendication 9, caractérisé en ce que l'on épitaxie sur le film semiconducteur (6) une couche semi-conductrice (16), les source et drain étant alors formés dans la couche épitaxiée et la couche conductrice enterrée (12, 7) dans le film semi-conducteur (6).

11. Procédé selon l'une quelconque des revendications 8 à 10, caractérisé en ce que les étapes f et g sont réalisées simultanément dans ledit matériau conducteur dopé, par dépôt de ce matériau dopé (30) sur le circuit intégré puis gravure selon les motifs voulus.

12. Procédé selon l'une quelconque des revendications 8 à 11, caractérisé en ce que le matériau conducteur dopé est du silicium polycristallin dopé.

13. Procédé selon l'une quelconque des revendications précédentes, caractérisé en ce que l'îlot (18) est en silicium monocristallin et la couche isolante (4) en oxyde ou nitrure de silicium.

EP 0 462 882 A1

FIG.1A

FIG.3A

FIG.1B

FIG.3B

FIG.3C

FIG.1C

FIG.3D

9

FIG.1D

FIG.3E

FIG.1E

FIG.3F

FIG.1F

FIG.3G

FIG.1G

FIG.3H

FIG.1H

FIG. 3I

FIG. 1I

FIG. 3J

FIG. 1J

FIG. 3K

FIG.1K

FIG.3L

FIG. 2

FIG. 4

Office européen
des brevets

**RAPPORT DE RECHERCHE EUROPEENNE**

Numero de la demande

EP 91 40 1613

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | GB-A-2070858 (RAYTHEON COMPANY)<br>* le document en entier * | 1, 6, 7,<br>8, 11,<br>12, 13 | H01L29/784<br>H01L29/808<br>H01L21/74 |
| | --- | | |
| A | US-A-4371886 (BELL TELEPHONE LABORATORIES)<br>* abrégé; figure 1 *<br>* colonne 2, ligne 55 - colonne 3, ligne 25 * | 1, 7 | |
| | --- | | |
| A | EP-A-219831 (NEC CORPORATION)<br>* abrégé; figures 3-6 *<br>* colonne 3, ligne 45 - colonne 4, ligne 41 * | 2, 3 | |
| | --- | | |
| A | EP-A-9910 (FUJITSU LIMITED)<br>* abrégé; figures 6-7 *<br>* page 10, lignes 10 - 31 * | 3 | |
| | --- | | |
| A | EP-A-225821 (FUJITSU LIMITED)<br>* abrégé; figure 2A * | 1, 4, 6 | |
| | ----- | | |

DOMAINES TECHNIQUES RECHERCHES (Int. Cl.5)

H01L

Le présent rapport a été établi pour toutes les revendications

| Lieu de la recherche | Date d'achèvement de la recherche | Examinateur |
|---|---|---|
| LA HAYE | 09 AOUT 1991 | MIMOUN B.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)